# EUROPÄISCHE PATENTSCHRIFT

(11) **EP 0 842 544 B1**
(45) Veröffentlichungstag und Bekanntmachung des Hinweises auf die Patenterteilung: **12.12.2001**
(21) Anmeldenummer: 96921897.3
(22) Anmeldetag: 05.07.1996
(51) Int. Cl.: H01L 31/112, H01L 31/0352

(54) **PHOTODIODE UND VERFAHREN ZU DEREN HERSTELLUNG**
PHOTODIODE AND PROCESS FOR MANUFACTURING THE SAME
PHOTODIODE ET SON PROCEDE DE FABRICATION

(30) Priorität: 03.08.1995 DE 19528573
(43) Veröffentlichungstag der Anmeldung: 20.05.1998
(73) Patentinhaber: Osram Opto Semiconductors GmbH & Co. OHG, 93049 Regensburg (DE)
(72) Erfinder: OPPERMANN, Klaus-Günter, D-83607 Holzkirchen (DE)
(74) Vertreter: Epping, Wilhelm, Dipl.-Ing.
(86) Internationale Anmeldenummer: DE9601210
(87) Internationale Veröffentlichungsnummer: WO9706566

(56) Entgegenhaltungen:
- US-A- 4 733 286
- US-A- 5 360 987
- APPLIED PHYSICS LETTERS, Bd. 37, Nr. 11, 1.Dezember 1980, Seiten 1014-1016, XP002018003 C.W. CHEN AND T.K. GUSTAFSON: "A high-speed Si lateral photodetector over an etched interdigital mesa"
- SZE S M: "Physics of Semiconductor devices; Chapter 14" , 1969, LONDON, UK, WILEY-INTERSCIENCE, UK , ISBN 0-471-84290-7 XP002018113 in der Anmeldung erwähnt siehe Absatz 14.3.4; Abbildung 19
- IEEE TRANS. ON ELECTRON DEVICES, Bd. ED-26, Nr. 7, Juli 1979, Seiten 1091-1097, XP002018004 T.I. CHAPPEL: "The V-groove multijunction solar cell"
- APPLIED PHYSICS LETTERS, Bd. 41, Nr. 10, 15.November 1982, Seiten 944-946, XP002018005 F. CAPASSO ET AL.: "Channeling photodiode: A new versatile interdigitated pn junction photodetector"

## Beschreibung

In verschiedenen integrierten Schaltungsanordnungen, z.B. in Optokopplern und elektronischen Relais, werden Photodioden als integrierte Energie- und Signalquelle eingesetzt. Für diese Anwendung sollen die Photodioden eine hohe Leerlaufspannung, einen hohen Kurzschlußstrom und eine maximale Leistungsabgabe aufweisen. Die von der Photodiode gelieferte Leistung hängt dabei vom Innenwiderstand der Photodiode ab. Der Innenwiderstand wird durch den Serienwiderstand,der sich aus den Schichtwiderständen der Diffusionsgebiete der Photodiode, den Kontaktwiderständen der Metallisierungen der Photodiode und der Leitungswiderstände der Metallisierungen ergibt, gebildet (siehe z.B. S.M. Sze "Physics of Semiconductor Devices", Wiley, New York, Kap. 14.3.2).

Photodioden, die als Einzelbauelemente gefertigt werden, werden zur Verringerung des Serienwiderstandes und zur Erhöhung der Photonenausbeute mit Rückseitenkontakten und speziellen Geometrien zur Reflexion des Lichtes, z.B. V-Grabenstrukturen, versehen (siehe z.B. S.M. Sze "Physics of Semiconductor Devices", Wiley, New York, Kap. 14.3.4).

Photodioden, die in einem Substrat integriert hergestellt werden, können nicht mit Rückseitenkontakten oder Reflexionsstrukturen versehen werden. Photodioden, die in einem Substrat integriert werden, weisen in der Nähe der Oberseite des Bauelementes einen pn-Übergang auf, durch den im Silizium durch Photonen erzeugte Elektronen und Löcher voneinander getrennt werden. Die p- und n-dotierten Gebiete werden dabei über schmale, hochdotierte n- bzw. p-dotierte Streifen elektrisch angeschlossen. Die hochdotierten Streifen weisen einen hohen Innenwiderstand auf. Durch eine Metallisierungsschicht, die Kontakte über die gesamte Länge der hochdotierten Streifen aufweist, wird der Schichtwiderstand der Leitung reduziert. Gleichzeitig wird ein Teil der photoempfindlichen Fläche der Photodiode abgedeckt, so daß die Photonenausbeute reduziert wird.

In der Druckschrift US-A-5360987 ist eine Photodiode angegeben, welche ein erstes und ein zweites dotiertes Gebiet aufweist, welche einen pn-Übergang bilden. Das aktive Gebiet der Photodiode ist dabei gegenüber dem Substrat elektrisch isoliert.

Der Erfindung liegt das Problem zugrunde, eine Photodiode anzugeben, die in einer integrierten Schaltung herstellbar ist und die einen reduzierten Serienwiderstand aufweist. Ferner soll ein Verfahren zu deren Herstellung angegeben werden.

Dieses Problem wird erfindungsgemäß gelöst durch eine Photodiode nach Anspruch 1 sowie ein Verfahren zu deren Herstellung nach Anspruch 4. Weitere Ausgestaltungen der Erfindung ergeben sich aus den übrigen Ansprüchen.

Die erfindungsgemäße Photodiode ist in einem Substrat integriert und durch dielektrische Isolation gegen das Substrat isoliert. Dazu weist das Substrat eine Trägerscheibe, eine darauf angeordnete, isolierende Schicht und eine darauf angeordnete monokristalline Siliziumschicht auf. Als Substrat ist z.B. ein sog. SOI-Substrat geeignet, das auf einer Siliziumscheibe eine isolierende Schicht und darauf eine monokristalline Siliziumschicht umfaßt. In der monokristallinen Siliziumschicht ist ein Graben vorgesehen, der von einer Hauptfläche der Siliziumschicht bis auf die isolierende Schicht reicht. Der Graben ist mit isolierendem Material gefüllt. Der Graben ist z. B. mit SiO₂ gefüllt oder mit SiO₂ ausgekleidet und mit Polysilizium aufgefüllt. Der Graben umgibt ein aktives Gebiet in der Siliziumschicht vollständig. Das aktive Gebiet ist nach unten hin durch die isolierende Schicht gegen die Trägerscheibe isoliert.

In dem aktiven Gebiet ist ein erstes dotiertes Gebiet vorgesehen, daß dem Graben unmittelbar benachbart ist. Das erste dotierte Gebiet reicht von der Hauptfläche der Siliziumschicht bis auf die isolierende Schicht. Das erste dotierte Gebiet ist von einem ersten Leitfähigkeitstyp, z.B. p, dotiert. Vorzugsweise weist das erste dotierte Gebiet an der Grenzfläche zum Graben eine Dotierstoffkonzentration im Bereich zwischen 10¹⁸ cm⁻³ und 10²⁰ cm⁻³ bei einer Eindringtiefe von z. B. 3*µ*m auf.

In dem aktiven Gebiet ist ferner ein zweites dotiertes Gebiet vorgesehen, das von einem zweiten, dem ersten entgegengesetzten Leitfähigkeitstyp, z.B. n, dotiert ist. Das zweite dotierte Gebiet bildet mit dem ersten dotierten Gebiet einen pn-Übergang, der die Photodiode darstellt.

An der Hauptfläche der Siliziumschicht sind jeweils Kontakte für das erste dotierte Gebiet und für das zweite dotierte Gebiet angeordnet. Im Hinblick auf einen möglichst geringen Anschlußwiderstand sind diese Kontakte vorzugsweise auf Anschlußgebieten erhöhter Dotierstoffkonzentration angeordnet.

Da das erste dotierte Gebiet von der Hauptfläche bis auf die isolierende Schicht reicht, ist die Fläche des für die Photodiode wirksamen pn-Überganges gegenüber der an der Hauptfläche benötigten Fläche für die Photodiode vergrößert. Ferner wird der maximal nötige Diffusionsweg der durch einfallende Photonen erzeugten Ladungsträger zum nächsten pn-Übergang verringert. Schließlich stellt das erste dotierte Gebiet einen niederohmigen Pfad für die Ladungsträger dar. Außerhalb der Kontakte zu den dotierten Gebieten ist an der Hauptfläche keine Abdeckung durch Metallkontakte oder Metall-Leiterbahnen vorgesehen. D.h. praktisch die gesamte Oberfläche des aktiven Gebietes steht für den Lichteinfall zur Verfügung.

In dem aktiven Gebiet ist mindestens ein weiterer Graben angeordnet, der von der Hauptfläche bis auf die isolierende Schicht reicht und der mit isolierendem Material aufgefüllt ist. Ferner ist in dem aktiven Gebiet ein drittes dotiertes Gebiet vorgesehen, das vom ersten Leitfähigkeitstyp, z.B. p, dotiert ist, und daß dem weiteren Graben unmittelbar benachbart ist. Das dritte dotierte Gebiet reicht von der Hauptflä che der Siliziumschicht bis auf die isolierende Schicht. Das dritte dotierte Gebiet bewirkt, daß die Fläche des pnÜbergangs weiter vergrößert wird. Außerdem kann auf diese Weise der maximal nötige Diffusionsweg weiter verringert werden. Die Anzahl der weiteren Gräben kann nahezu beliebig gewählt werden. Eine obere Grenze ist lediglich durch den Prozeß, d. h. z. B. durch Grabenbreite, Diffusionstiefe der dritten dotierten Gebiete, Photolithographie, o. ä. gegeben.

Vorzugsweise wird der Graben mit SiO₂ aufgefüllt. Da SiO₂ einen kleineren Brechungsindex als Silizium aufweist, kann in das isolierende Material im Graben eingefallenes Licht durch Brechung in das optisch dichtere Silizium eindringen und ebenfalls zur Ladungsträgergeneration beitragen. Der Grenzwinkel für Totalreflexion von Silizium/SiO₂ beträgt 23°. Daher findet daher kaum Brechung aus dem Silizium in das SiO₂ statt.

Es ist vorteilhaft, den oder die Gräben mit schrägen Seitenwänden vorzusehen, da dann die Brechung von Licht aus dem Graben aus SiO₂ in das aktive Gebiet aus Silizium weiter verbessert wird.

Vorzugsweise werden das erste dotierte Gebiet und das dritte dotierte Gebiet durch Ausdiffusion aus einer im Graben befindlichen Dotierstoffquelle erzeugt. Dazu wird nach der Grabenätzung eine dotierte Schicht erzeugt, die mindestens die Seitenwände des Grabens bedeckt. Als dotierte Schicht ist z.B. dotiertes Glas oder dotiertes polykristallines oder amorphes Silizium geeignet. Das erste dotierte Gebiet bzw. das dritte dotierte Gebiet werden durch Ausdiffusion aus der dotierten Schicht in einem Temperschritt erzeugt.

Bei Verwendung einer dotierten Siliziumschicht als Dotierstoffquelle liegt es im Rahmen der Erfindung, den Temperschritt so zu führen, daß gleichzeitig mit der Ausdiffusion des Dotierstoffes eine Aufoxidation der dotierten Siliziumschicht erfolgt, bei der der Graben mit SiO₂ aufgefüllt wird.

Die erfindungsgemäße Photodiode ist durch den umgebenden Graben und die isolierende Schicht vollständig gegen das Substrat dielektrisch isoliert. Das Substrat kann daher nebeneinander eine Vielzahl von Photodioden umfassen, die elektrisch voneinander völlig unabhängig sind. Sind diese Photodioden in einer Serienschaltung angeordnet, so entspricht die gelieferte Spannung der Serienschaltung der Summe der Einzelspannungen der einzelnen Photodioden. Damit ist die erfindungsgemäße Photodiode geeignet, in einer Serienschaltung mit einer Vielzahl von Photodioden die erforderliche Spannung zur Ansteuerung eines Hochspannungs-MOSFETs zu liefern. Es treten bei der erfindungsgemäßen Photodiode keine Leckstromprobleme zum Substrat auf. Darüberhinaus ist der Platzbedarf für die Isolation, die durch den mit isolierendem Material gefüllten Graben bewerkstelligt wird, minimal.

Im folgenden wird die Erfindung anhand eines Ausführungsbeispiels und der Figuren näher erläutert.
- Figur 1: zeigt eine Aufsicht auf eine Photodiode mit zwei weiteren Gräben im aktiven Gebiet.
- Figur 2: zeigt den in Figur 1 mit II-II bezeichneten Schnitt durch die Photodiode.

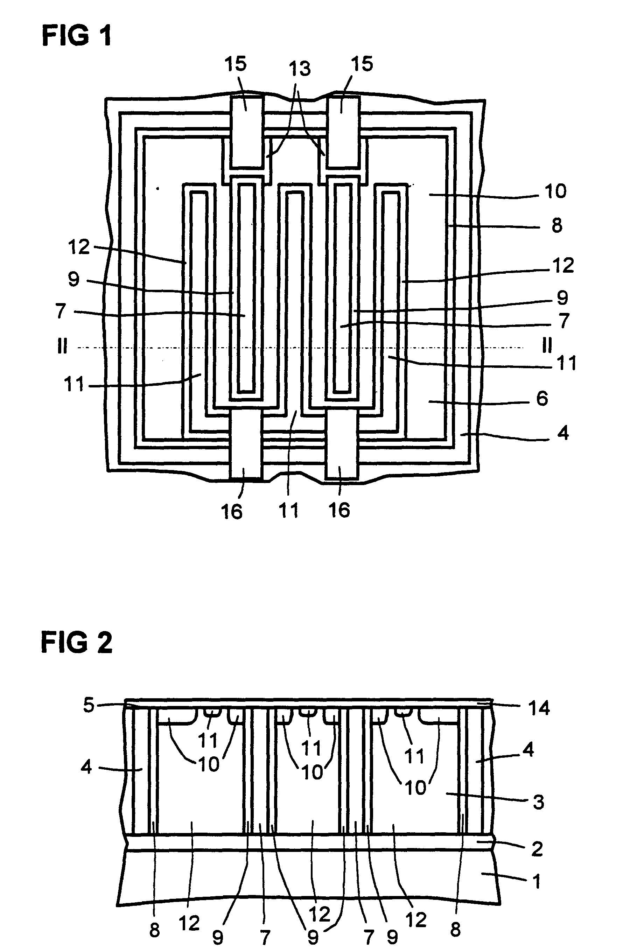

Ein SOI-Substrat umfaßt eine Siliziumscheibe 1, auf der eine isolierende Schicht 2 und eine monokristalline Siliziumschicht 3 angeordnet sind (s. Figur 2). Die isolierende Schicht 2 besteht z.B. aus SiO₂ und weist eine Dicke von z.B. 1 µm auf. Die monokristalline Siliziumschicht 3 weist eine Dicke von z.B. 20 µm auf und ist z.B. n-dotiert mit einer Dotierstoffkonzentration von 6 x 10¹⁴ cm⁻³.

In der monokristallinen Siliziumschicht 3 ist ein Graben 4 angeordnet, der von einer Hauptfläche 5 der monokristallinen Siliziumschicht bis auf die isolierende Schicht 2 reicht (s. Figur 1 und Figur 2). Der Graben 4 umschließt ein aktives Gebiet 6 vollständig. Der Graben 4 ist mit isolierendem Material, z.B. SiO₂, gefüllt. Der Graben 4 weist eine Weite von z.B. 3 µm auf. Das aktive Gebiet 6, das von dem Graben 4 umschlossen wird, weist Abmessungen von z.B. 200 µm x 200 µm auf.

In dem aktiven Gebiet 6 sind zwei weitere Gräben 7 angeordnet, die jeweils von der Hauptfläche 5 bis auf die isolierende Schicht 2 reichen. Die weiteren Gräben 7 sind streifenförmig und haben keine Verbindung zu dem Graben 4. Die weiteren Gräben 7 sind ebenfalls mit isolierendem Material, z.B. SiO₂, aufgefüllt.

In dem aktiven Gebiet 6 ist dem Graben 4 benachbart ein erstes dotiertes Gebiet 8 angeordnet. Das erste dotierte Gebiet 8 ist z.B. p⁺-dotiert und weist an der Grenzfläche zum Graben 4 eine Dotierstoffkonzentration von z.B. 10¹⁹ cm⁻² auf. Die Eindringtiefe beträgt z. B. 3 µm. Das erste dotierte Gebiet 8 reicht von der Hauptfläche 5 bis auf die isolierende Schicht 2. Das erste dotierte Gebiet 8 grenzt dabei unmittelbar an den Graben 4 an. Das erste dotierte Gebiet 8 umgibt das aktive Gebiet 6 ringförmig.

In dem aktiven Gebiet 6 sind ferner zwei dritte dotierte Gebiete 9 vorgesehen, die jeweils einem der weiteren Gräben 7 benachbart angeordnet sind. Das jeweilige dritte dotierte Gebiet 9 umgibt dabei den weiteren Graben 7 jeweils ringförmig. Die dritten dotierten Gebiete 9 reichen von der Hauptfläche 5 bis auf die isolierende Schicht 6. Die dritten dotierten Gebiete 9 sind z.B. p⁺-dotiert und weisen an der Grenzfläche zum jeweiligen weiteren Graben7 eine Dotierstoffkonzentration im Bereich von 10¹⁸ cm⁻³ bis 10²⁰ cm⁻³ auf.

An der Hauptfläche 5 sind ferner p-dotierte Wannen 10 angeordnet, die jeweils an den Graben 4 bzw. einen der weiteren Gräben 7 angrenzen. Die p-dotierten Wannen 10 weisen eine Dotierstoffkonzentration im Bereich zwischen 10¹⁶ cm⁻³ und 10¹⁹ cm⁻³ und eine Tiefe von z.B. 2 *µ*m auf.

An der Hauptfläche 5 ist ein n⁺-dotiertes Anschlußgebiet 11 angeordnet, das vollständig von einem zweiten dotierten Gebiet 12 umgeben ist, das aus dem Grundmaterial der n-dotierten monokristallinen Schicht 3 gebildet wird. Das n⁺-dotierte Anschlußgebiet 11 umfaßt mehrere streifenförmige Elemente, die jeweils zwischen den weiteren Gräben 7 bzw. zwischen einem der weiteren Gräben 7 und dem Graben 4 angeordnet sind und die durch ein weiteres, senkrecht dazu angeordnetes streifenförmiges Verbindungselement miteinander verbunden sind.

An der Hauptfläche 5 sind ferner p⁺-dotierte Anschlußgebiete 13 vorgesehen, die jeweils am Rand des aktiven Gebietes 6 angeordnet sind, und die jeweils eines der dritten dotierten Gebiete 9 und das erste dotierte Gebiet 8 teilweise überlappen. Die p⁺-dotierten Anschlußgebiete 13 stellen eine elektrische Verbindung zwischen dem ersten dotierten Gebiet 8 und dem jeweiligen dritten dotierten Gebiet 9 dar. Die p⁺-dotierten Anschlußgebiete 13 weisen eine Dotierstoffkonzentration von z.B. 10¹⁹ cm⁻³ auf.

Die n⁺-dotierten Anschlußgebiete 11 sowie die p⁺-dotierten Anschlußgebiete 13 weisen eine Tiefe von jeweils etwa 0,8 *µ*m auf.

Mindestens das aktive Gebiet 6 ist an der Hauptfläche 5 mit einer Passivierungsschicht 14 versehen. Die Passivierungsschicht 14 wird in Dicke und Material auf die Wellenlänge des nachzuweisenden Lichtes abgestimmt, so daß sie für dieses durchlässig ist. Insbesondere ist als Passivierungsschicht SiO₂ oder Si₃N₄ geeignet. Die Passivierungsschicht 14 weist eine Dicke von z.B. 1 µm auf.

Oberhalb der p⁺-dotierten Anschlußgebiete 13 sind auf der Passivierungsschicht 14 Kontakte 15 aus z.B. Aluminium, angeordnet, die über ein Kontaktloch in der Passivierungsschicht 14 mit dem jeweiligen p⁺-dotierten Anschlußgebiet verbunden sind. Im Bereich des streifenförmigen Verbindungselementes des n⁺-dotierten Anschlußgebietes 11 sind z.B. zwei Kontakte 16 aus z.B. Aluminium angeordnet, die jeweils über Kontaktlöcher mit dem n⁺-dotierten Anschlußgebiet 11 verbunden sind. Vorzugsweise sind die Kontakte 15 zu den p⁺-dotierten Anschlußgebieten und die Kontakte 16 zu dem n⁺-dotierten Anschlußgebiet 11 symmetrisch angeordnet, da sich dieses vorteilhaft auf die Stromverteilung in der Photodiode auswirkt.

Das zweite dotierte Gebiet 12, das aus dem Grundmaterial der monokristallinen Siliziumschicht 3 gebildet wird, bildet mit dem angrenzenden ersten dotierten Gebiet 8, dritten dotierten Gebiete 9 sowie den p-dotierten Wannen 10 einen pn-Übergang, der die Photodiode bildet. Die p⁺-Dotierung in dem ersten dotierten Gebiet 8 und den dritten dotierten Gebieten 9 gewährleistet dabei eine gute Leitfähigkeit. Die p-Dotierung der p-dotierten Wannen 10 gewährleistet eine im Oberflächenbereich nur geringfügig veränderte Bandlücke und damit nur geringfügig veränderte Absorptionseigenschaften des Siliziums.

Zur Herstellung der erfindungsgemäßen Photodiode wird in der monokristallinen Siliziumschicht 3 nach Bildung einer Maske durch photolithographische Prozeßschritte der Graben 4 und die weiteren Gräben 7 durch anisotropes Ätzen, z.B. mit HBr, He, O₂, gebildet. Über die Parametern bei der anisotropen Ätzung werden die Seitenwände der Gräben 4, 7 senkrecht oder schräg zur Hauptfläche gebildet. Anschließend wird eine dotierte Schicht, z.B. aus Borsilikatglas oder p⁺-dotiertem Silizium, abgeschieden, die mindestens die Seitenwände der Gräben 4, 7 bedeckt. In einem Temperschritt bei z.B. 1000°C wird durch Ausdiffusion des Dotierstoffes aus der dotierten Schicht in die Seitenwände des Grabens 4 und der weiteren Gräben 7 das erste dotierte Gebiet 8 und die dritten dotierten Gebiete 9 gebildet. Anschließend werden der Graben 4 und die weiteren Gräben 7 mit isolierendem Material aufgefüllt. Dieses erfolgt z.B. nach Entfernen der dotierten Schicht in einem Ätzschritt durch die Abscheidung einer SiO₂-Schicht. Im Bereich der Hauptfläche 5 angeordnete Teile der SiO₂-Schicht werden durch planarisierende Ätzschritte entfernt.

Falls die dotierte Schicht aus dotiertem Silizium besteht, kann der Temperschritt so durchgeführt werden, daß bei der Ausdiffusion des Dotierstoffes zur Bildung des ersten dotierten Gebietes 8 und der dritten dotierten Gebiete 9 die dotierte Schicht aufoxidiert wird, und auf diese Weise der Graben 4 und die weiteren Gräben 7 mit SiO₂ aufgefüllt werden.

Die p-dotierte Wanne 10, das n⁺-dotierte Anschlußgebiet und die p⁺-dotierten Anschlußgebiete 13 werden anschließend durch maskierte Implantation gebildet.

Nach Abscheiden der Passivierungsschicht 14 werden in bekannter Weise Kontaktlöcher zu dem n⁺-dotierten Anschlußgebiet 11 und dem p⁺-dotierten Anschlußgebiet 13 geöffnet. Die Kontakte 15, 16 werden schließlich durch Abscheiden einer Metallisierungsschicht, z.B. aus Aluminium, und Strukturieren der Metallisierungsschicht fertiggestellt.

## Patentansprüche

1. Photodiode,
- bei der ein Substrat vorgesehen ist, das eine Trägerscheibe (1), eine darauf angeordnete isolierende Schicht (2) und eine darauf angeordnete monokristalline Siliziumschicht (3) umfaßt,
- bei der in der Siliziumschicht (3) mindestens ein Graben (4) vorgesehen ist, der von einer Hauptfläche (5) der Siliziumschicht (3) bis auf die isolierende Schicht (2) reicht, der mit isolierendem Material gefüllt ist und der ein aktives Gebiet (6) vollständig umgibt,
- bei der in dem aktiven Gebiet (6) ein erstes dotiertes Gebiet (8) vorgesehen ist, das von einem ersten Leitfähigkeitstyp mit einer Dotierstoffkonzentration im Bereich zwischen 10¹⁸cm⁻³ bis 10²⁰cm⁻³ dotiert ist, das dem Graben (4) unmittelbar benachbart ist und das von der Hauptfläche (5) der Siliziumschicht (3) bis auf die isolierende Schicht (2) reicht,
- bei der in dem aktiven Gebiet (6) ein zweites dotiertes Gebiet (3) vorgesehen ist, welches aus der monokristallinen Siliziumschicht (3) gebildet ist, das von einem zweiten, dem ersten entgegengesetzten Leitfähigkeitstyp dotiert ist, und das mit dem ersten dotierten Gebiet (8) einen pn-Übergang bildet,
- bei der an der Hauptfläche (5) der Siliziumschicht (3) jeweils ein Kontakt (15, 16) für das erste dotierte Gebiet und für das zweite dotierte Gebiet (12) angeordnet ist,
- bei der in dem aktiven Gebiet (6) mindestens ein weiterer Graben (7) angeordnet ist, der von der Hauptfläche (5) bis auf die isolierende Schicht (2) reicht und der mit isolierendem Material aufgefüllt ist,
- bei der in dem aktiven Gebiet (6) ein drittes dotiertes Gebiet (9) vorgesehen ist, das vom ersten Leitfähigkeitstyp dotiert ist, das dem weiteren Graben (7) unmittelbar benachbart ist und das von der Hauptfläche (5) der Siliziumschicht (3) bis auf die isolierende Schicht (2) reicht.

2. Photodiode nach Anspruch 1,
- bei der in dem aktiven Gebiet (6) mindestens eine vom ersten Leitfähigkeitstyp dotierte Wanne (10) vorgesehen ist, die an die Hauptfläche (5) angrenzt, und die mit einem Kontakt (15) versehen ist.

3. Photodiode nach Anspruch 1 oder 2,
- bei der der oder die Gräben (4, 7) schräge Seitenwände aufweisen, so daß der Grabenquerschnitt an der Hauptfläche (5) größer als am Grabenboden ist.

4. Verfahren zur Herstellung einer Photodiode,
bei dem in einem Substrat, das eine Trägerscheibe (1), eine darauf angeordnete isolierende Schicht (2) und eine darauf angeordnete monokristalline Siliziumschicht (3) umfaßt, in der Siliziumschicht (3) ein Graben (4) erzeugt wird, der von einer Hauptfläche (5) der Siliziumschicht bis auf die isolierende Schicht (2) reicht und der ein aktives Gebiet (6) vollständig umgibt,
- bei dem die Seitenwände des Grabens (4) dotiert werden, so daß ein erstes dotiertes Gebiet (8) entsteht, das von einem ersten Leitfähigkeitstyp mit einer Dotierstoffkonzentration im Bereich zwischen 10¹⁸ cm⁻³ und 10²⁰ cm⁻³ dotiert ist, das dem Graben unmittelbar benachbart ist und das von der Hauptfläche (5) der Siliziumschicht (3) bis auf die isolierende Schicht (2) reicht,
- bei dem Graben (4) mit isolierendem Material aufgefüllt wird,
- bei dem in dem aktiven Gebiet (6) ein pn-Übergang gebildet wird zwischen dem ersten dotierten Gebiet (8) und einem zweiten dotierten Gebiet (12), welches aus der monokristallinen Siliziumschicht (3) gebildet und von einem zweiten, dem ersten entgegengesetzten Leitfähigkeitstyp dotiert ist,
- bei dem an der Hauptfläche (5) der Siliziumschicht (3) jeweils ein Kontakt (15, 16) für das erste dotierte Gebiet (8) und für das zweite dotierte Gebiet (12) erzeugt werden,
- bei dem bei der Erzeugung des Grabens (4) in dem aktiven Gebiet mindestens ein weiterer Graben (7) gebildet wird,
- bei dem die Seitenwände des weiteren Grabens (7) dotiert werden, so daß ein drittes dotiertes Gebiet (9) entsteht, das von dem ersten Leitfähigkeitstyp dotiert ist, das dem Graben (7) unmittelbar benachbart ist und das von der Hauptfläche (5) der Siliziumschicht (3) bis auf die isolierende Schicht (2) reicht,
- bei dem der weitere Graben (7) mit isolierendem Material aufgefüllt wird,
- bei dem an der Hauptfläche (5) der Siliziumschicht (3) ein Kontakt zu dem dritten dotierten Gebiet (9) erzeugt wird.

5. Verfahren nach Anspruch 4,
- bei dem zur Bildung des ersten dotierten Gebietes (8) eine dotierte Schicht erzeugt wird, die die Seitenwände des Grabens (4) bedeckt,
- bei dem das erste dotierte Gebiet (8) die Ausdiffusion aus der dotierten Schicht in einem Temperschritt erzeugt wird.

6. Verfahren nach Anspruch 4 oder 5,
- bei dem der oder die Gräben (4, 7) mit schrägen Seitenwänden erzeugt werden, so daß der Grabenquerschnitt an der Hauptfläche (5) größer als am Grabenboden ist.

## Claims

1. Photodiode,
- in which a substrate is provided which comprises a carrier wafer (1), an insulating layer (2) arranged thereon, and a monocrystalline silicon layer (3) arranged thereon,
- in which at least one trench (4) is provided in the silicon layer (3), which trench reaches from a main area (5) of the silicon layer (3) down to the insulating layer (2), is filled with insulating material and completely surrounds an active region (6),
- in which a first doped region (8) is provided in the active region (6), which doped region is doped by a first conductivity type with a dopant concentration in the range between 10¹⁸cm⁻³ and 10²⁰cm⁻³, is directly adjacent to the trench (4) and reaches from the main area (5) of the silicon layer (3) down to the insulating layer (2),
- in which a second doped region (3) is provided in the active region (6), which doped region is formed from the monocrystalline silicon layer (3), is doped by a second conductivity type, opposite to the first conductivity type, and forms a pn junction with the first doped region (8),
- in which a respective contact (15, 16) for the first doped region and for the second doped region (12) is arranged at the main area (5) of the silicon layer (3),
- in which at least one further trench (7) is arranged in the active region (6), which trench reaches from the main area (5) down to the insulating layer (2) and is filled with insulating material,
- in which a third doped region (9) is provided in the active region (6), which doped region is doped by the first conductivity type, is directly adjacent to the further trench (7) and reaches from the main area (5) of the silicon layer (3) down to the insulating layer (2).

2. Photodiode according to Claim 1,
- in which at least one well (10) doped by the first conductivity type is provided in the active region (6), which well adjoins the main area (5) and is provided with a contact (15).

3. Photodiode according to Claim 1 or 2,
- in which the trench or trenches (4, 7) has or have inclined side walls, with the result that the trench cross section is larger at the main area (5) than at the trench bottom.

4. Method for fabricating a photodiode,
in which, in a substrate comprising a carrier wafer (1), an insulating layer (2) arranged thereon, and a monocrystalline silicon layer (3) arranged thereon, a trench (4) is produced in the silicon layer (3), which trench reaches from a main area (5) of the silicon layer down to the insulating layer (2) and completely surrounds an active region (6).
- in which the side walls of the trench (4) are doped to produce a first doped region (8), which is doped by a first conductivity type with a dopant concentration in the range between 10¹⁸ cm⁻³ and 10²⁰ cm⁻³, is directly adjacent to the trench and reaches from the main area (5) of the silicon layer (3) down to the insulating layer (2),
- in which trench (4) is filled with insulating material,
- in which, in the active region (6), a pn junction is formed between the first doped region (8) and a second doped region (12), which is formed from the monocrystalline silicon layer (3) and is doped by a second conductivity type, opposite to the first conductivity type,
- in which a respective contact (15, 16) for the first doped region (8) and for the second doped region (12) are produced at the main area (5) of the silicon layer (3),
- in which at least one further trench (7) is formed during the production of the trench (4) in the active region,
- in which the side walls of the further trench (7) are doped to produce a third doped region (9), which is doped by the first conductivity type, is directly adjacent to the trench (7) and reaches from the main area (5) of the silicon layer (3) down to the insulating layer (2),
- in which the further trench (7) is filled with insulating material,
- in which a contact to the third doped region (9) is produced at the main area (5) of the silicon layer (3).

5. Method according to Claim 4,
- in which, in order to form the first doped region (8), a doped layer is produced which covers the side walls of the trench (4),
- in which the first doped region (8) is produced by outdiffusion from the doped layer in a heat treatment step.

6. Method according to Claim 4 or 5,
- in which the trench or trenches (4, 7) is or are produced with inclined side walls, with the result that the trench cross section is larger at the main area (5) than at the trench bottom.

## Revendications

1. Photodiode,
- dans laquelle, il est prévu un substrat qui comprend une tranche (1) support, une couche (2) isolante disposée dessus et une couche (3) de silicium monocristalline disposée dessus,
- dans laquelle, il est prévu, dans la couche (3) de silicium, au moins un sillon (4) qui va d'une surface (5) principale de la couche (3) de silicium jusqu'à la couche (2) isolante, qui est empli de matière isolante et qui entoure entièrement une zone (6) active,
- dans laquelle, il est prévu, dans la zone (6) active, une première zone (8) dopée qui est dopée par un premier type de conductivité à une concentration de la substance de dopage de l'ordre de 10¹⁸cm⁻³ à 10²⁰ cm⁻³, qui est immédiatement voisine du sillon (4) et qui va de la surface (5) principale de la couche (3) de silicium jusqu'à la couche (2) isolante,
- dans laquelle, il est prévu, dans la zone (6) active, une deuxième zone (3) dopée qui est formée dans la couche (3) de silicium monocristalline, qui est dopée par un deuxième type de conductivité opposé au premier et qui forme avec la première zone (8) dopée une jonction pn,
- dans laquelle, il est prévu, sur la surface (5) principale de la couche (3) de silicium, respectivement un contact (15, 16) pour la première zone dopée et pour la deuxième zone (12) dopée,
- dans laquelle, il est prévu, dans la zone (6) active, au moins un autre sillon (7) qui va de la surface (5) principale jusqu'à la couche (2) isolante et qui est empli de matière isolante,
- dans laquelle, il est prévu, dans la zone (6) active, une troisième zone (9) dopée qui est dopée par le premier type de conductivité, qui est immédiatement voisine de l'autre sillon (7) et qui va de la surface (5) principale de la couche (3) de silicium jusqu'à la couche (2) isolante.

2. Photodiode suivant la revendication 1,
- dans laquelle, il est prévu, dans la zone (6) active, au moins une cuvette (10) dopée par le premier type de conductivité, qui est adjacente à la surface (5) principale et qui est munie d'un contact (15).

3. Photodiode suivant la revendication 1 ou 2,
- dans laquelle le ou les sillons (4, 7) ont des parois latérales inclinées, de sorte que la section transversale du sillon sur la surface (5) principale est plus grande qu'au fond du sillon.

4. Procédé de fabrication d'une photodiode,
dans lequel, on produit, dans un substrat qui comporte une tranche (1) support, une couche (2) isolante dessus et une couche (3) de silicium monocristalline dessus, dans la couche (3) de silicium, un sillon (4) qui va d'une surface (5) principale de la couche de silicium jusqu'à la couche (2) isolante et qui entoure entièrement une zone (6) active,
- dans lequel on dope les parois latérales du sillon (4) de façon à former une première zone (8) dopée, qui est dopée par un premier type de conductivité à une concentration de substance de dopage de l'ordre de 10¹⁸ cm⁻³ à 10²⁰ cm⁻³, qui est immédiatement voisine du sillon et qui va de la surface (5) principale de la couche (3) de silicium jusqu'à la couche (2) isolante,
- dans lequel on emplit le sillon (4) de matière isolante,
- dans lequel, on forme dans la zone (6) active, une jonction pn entre la première zone (8) dopée et une deuxième zone (12) dopée qui est formée dans la couche (3) de silicium monocristalline et qui est dopée par un deuxième type de conductivité opposé au premier,
- dans lequel, on produit sur la surface (5) principale de la couche (3) de silicium, respectivement un contact (15, 16) pour la première zone (8) dopée et pour la deuxième zone (12) dopée,
- dans lequel, on forme, lors de la production du sillon (4) dans la zone active, au moins un autre sillon (7),
- dans lequel, on dope les parois latérales de l'autre sillon (7) de manière à former une troisième zone (9) dopée qui est dopée par le premier type de conductivité, qui est immédiatement voisine du sillon (7) et qui va de la surface (5) principale de la couche (3) de silicium jusqu'à la couche (2) isolante,
- dans lequel, on emplit l'autre sillon (7) de matière isolante,
- dans lequel, on produit, à la surface (5) principale de la couche (3) de silicium, un contact vers la troisième zone (9) dopée.

5. Procédé suivant la revendication 4,
- dans lequel, on produit, pour former la première zone (8) dopée, une couche dopée qui recouvre les parois latérales du sillon (4),
- dans lequel, on produit la première zone (8) dopée par diffusion de la zone dopée dans un stade de recuit.

6. Procédé suivant la revendication 4 ou 5,
- dans lequel on produit le ou les sillons (4, 7) en leur donnant des parois latérales inclinées, de sorte que la section transversale du sillon à la surface (5) principale est plus grande qu'au fond du sillon.
